# DEMANDE DE BREVET EUROPEEN

(11) **EP 1 318 582 A1**
(43) Date de publication de la demande: **11.06.2003**
(21) Numéro de dépôt: 02292638.0
(22) Date de dépôt: 24.10.2002
(51) Int. Cl.: H01S 5/20, H01S 5/343

(54) **Laser à semi-conducteurs**

(30) Priorité: 31.10.2001 FR 0114164
(71) Demandeur: ALCATEL, 75008 Paris (FR)
(72) Inventeur: Bettiati, Mauro, 75005 Paris (FR); Starck, Christophe, 91700 Ste-Genevieve-des-Bois (FR); Lovisa, Stéphane, 75014 Paris (FR)
(74) Mandataire: Lamoureux, Bernard

(57) **Abrégé**

La présente invention concerne un laser à semi-conducteurs de structure verticale comportant des couches de revêtement inférieure et supérieure (1, 2), un guide optique (G) superposé à la couche de revêtement inférieure et une couche active semi-conductrice (CA). Le guide optique (G) selon l'invention comprend en outre :
- une couche guidante inférieure (11) semi-conductrice comprenant deux parties adjacentes dites inférieures suivantes :
   - une première partie inférieure (11a) non dopée adjacente à la région centrale,
   - une deuxième partie inférieure (11b) dopée de type n et adjacente à la couche de revêtement inférieure,
- une couche guidante supérieure (12) semi-conductrice comprenant deux parties adjacentes dites supérieures suivantes:
   - une première partie supérieure (12a) non dopée adjacente à la région centrale,
   - une deuxième partie supérieure (12b) dopée de type p et adjacente à la couche de revêtement supérieure,

De plus, les premières parties inférieure et supérieure forment une région non dopée (ND) d'épaisseur supérieure à 0,5 µm et la différence d'indice optique (Δnₒₚₜ) entre au moins l'une des couches de revêtement et ladite couche guidante adjacente est inférieure à 0,02.

## Description

La présente invention concerne le domaine des composants optiques semi-conducteurs. Plus précisément, elle concerne un laser à semi-conducteurs.

De manière connue, les lasers à semi-conducteurs sont utilisés dans de nombreuses applications et notamment pour le pompage de lasers solides ou d'amplificateurs optiques à fibres dopées terres rares. Le fonctionnement de ces lasers est basé sur l'utilisation d'une couche dite active à base d'arsenic, de gallium et/ou de phosphore et d'indium. Une fois alimentée en courant de porteurs de charge de type p et n, la couche active émet des rayonnements qui peuvent être amplifiés et correspondre à des rayonnements lasers, de longueurs d'onde généralement comprises dans une bande autour de 808 nm, 920 nm, 940 nm, 1480 nm, et en particulier 980 nm, cette dernière longueur d'onde étant utilisée pour le pompage des amplificateurs à fibre monomode employés dans les applications de télécommunications optiques.

Un tel laser souvent de type parallélépipédique peut posséder des faces latérales avant et arrière clivées pour former des miroirs facettés afin que s'établissent dans le laser des modes de propagation longitudinaux de type Fabry-Pérot : on parle de multimodalité dans le domaine spectral. De plus, ce type de composant est monomode dans le domaine spatial de type TE (Transverse Electrique).

Dans tout ce qui suit, le terme couche peut désigner une couche unique ou une superposition de couches remplissant la même fonction.

Les lasers à semi-conducteurs haute puissance fournissent une puissance optique de sortie élevée. Ces lasers sont d'autant plus performants qu'ils possèdent de faibles pertes internes ainsi qu'une faible divergence verticale des rayonnements lasers en sortie notamment afin d'optimiser le taux de couplage dans une fibre optique.

La réduction de la divergence verticale en sortie s'obtient par exemple par une modification des propriétés de guidage du mode optique et notamment par un étalement vertical plus important de ce mode optique, ce qui conduit à une augmentation des pertes internes. Ces deux paramètres étant liés un compromis est donc généralement réalisé pour les ajuster en même temps.

Le brevet US-5594749 divulgue un laser à semi-conducteurs conçu pour présenter une faible VFF (Vertical Far Field en anglais) c'est-à-dire une divergence inférieure à 30°. Dans un des modes de réalisations présentés, ce laser comprend notamment les couches successives suivantes:
- une couche de revêtement inférieure dopée n et en Al_{0,40}Ga_{0,60}As, d'épaisseur égale à 2,5 µm,
- une couche barrière inférieure non dopée et d'indice optique linéairement variable soit de type GRIN (GRaded INdex en anglais) en AlₓGa₁₋ₓAs, x variant de 0,40 à 0,25, d'épaisseur égale à 100 nm,
- une couche active à puits quantique non dopée, en GaAs, d'épaisseur égale à 7 nm,
- une couche barrière supérieure non dopée et de type GRIN en AlₓGa₁₋ₓAs, x variant de 0,25 à 0,40, d'épaisseur égale à 100 nm,
- ces trois dernières couches étant inclues dans une région dite guide optique d'épaisseur égale à 0,27 µm,
et une couche de revêtement supérieure dopée p, en Al_{0,40}Ga_{0,60}As, d'épaisseur égale à 1,85 µm.

Les performances en terme de divergence et de pertes internes-pertes données par le coefficient d'absorption du rayonnement (en cm⁻¹) dans les régions de pertes - sont présentées sous forme de graphiques en fonction de l'épaisseur choisie pour les couches de revêtement dopées.

Ces graphiques montrent que, pour une épaisseur donnée, la divergence est d'autant plus réduite que le taux d'aluminium est faible, contrairement à l'absorption.

Dans tous les modes de réalisation présentés, le guide optique de ce laser forme un région centrale non dopée de faible épaisseur de sorte que les perte internes ne sont pas totalement ajustées. En effet, les faibles divergences sont obtenues au prix d'une augmentation non négligeable des pertes internes.

La présente invention a pour but de mettre en oeuvre un laser à semi-conducteurs présentant à la fois des pertes internes et une divergence verticale minimisées ceci à partir d'une structure verticale de couches semi-conductrices simple et facile à réaliser.

A cet effet, la présente invention propose un laser à semi-conducteurs de structure verticale comportant:
- une couche de revêtement inférieure semi-conductrice et dopée de type n,
- un guide optique superposé à la couche de revêtement inférieure, ledit guide comportant une région centrale comprenant au moins une couche active semi-conductrice,
- une couche de revêtement supérieure, semi-conductrice, dopée de type p et superposée audit guide optique,
caractérisé en ce que ledit guide optique comprend en outre :
- une couche guidante inférieure semi-conductrice comprenant deux parties adjacentes dites inférieures suivantes :
   - une première partie inférieure non dopée adjacente à la région centrale,
   - une deuxième partie inférieure dopée de type n et adjacente à la couche de revêtement inférieure,
- une couche guidante supérieure semi-conductrice comprenant deux parties adjacentes dites supérieures suivantes :

- une première partie supérieure non dopée adjacente à la région centrale,
- une deuxième partie supérieure dopée de type p et adjacente à la couche de revêtement supérieure,
en ce que les premières parties inférieure et supérieure forment une région non dopée d'épaisseur supérieure à 0,5 µm,
et en ce que la différence d'indice optique entre au moins l'une des couches de revêtement et la couche guidante adjacente est inférieure à 0,02.

Du fait de l'insertion des couches guidantes selon l'invention, l'épaisseur du guide optique selon l'invention est donc nettement plus large que le guide optique des lasers de l'art antérieur. Ainsi, on obtient un étalement vertical du mode optique donnant un divergence verticale réduite en sortie du laser selon l'invention.

De plus, le faible saut d'indice, saut éventuellement égal à zéro, entre au moins l'une des couches de revêtement et la couche guidante qui lui est adjacente participe à cette réduction de la divergence.

Concernant les pertes internes, on sait que l'une des causes d'augmentation des pertes internes d'un laser vient de l'interaction entre les porteurs de charge de type n ou p et le champ électromagnétique du mode optique. Afin de limiter la pénétration du champ dans des zones dopées, les premières parties des couches guidantes selon l'invention sont non dopées. De cette façon, les pertes internes demeurent du même ordre que celles d'un guide optique plus mince à fort taux de confinement du champ électromagnétique et présentant une divergence plus élevée.

Les couches selon l'invention n'installent pas des barrières ou des puits de potentiels sur le chemin des porteurs de charges de type n ou de type p. Les comportements électriques et thermiques du laser selon l'invention sont donc satisfaisants.

Un laser haute puissance opérant généralement à un courant environ dix fois égal au courant seuil. La valeur du courant seuil du laser selon l'invention peut aisément être gardée à un niveau compatible avec le fonctionnement en haute puissance.

Avantageusement, l'épaisseur de la région non dopée peut être sensiblement égale à 0,8 µm. De préférence, la somme des épaisseurs des couches guidantes inférieure et supérieure selon l'invention peut être comprise entre 1,2 µm et 1,5 µm.

Ainsi, on se limite à des épaisseurs de couches guidantes telles que leur contribution à la résistance série du laser selon l'invention reste acceptable et telles qu'elles ne favorisent pas l'apparition de modes transverses supérieurs susceptibles de produire un rayonnement laser.

Dans un mode de réalisation avantageux, la différence d'indice optique entre au moins l'une des couches de revêtement et la couche guidante adjacente est sensiblement égale à zéro.

Ceci permet de réduire au maximum la divergence.

Les couches guidantes supérieure et inférieure selon l'invention peuvent être en un même matériau semi-conducteur et de préférence en un composé contenant de l'arsenic, du gallium et de l'aluminium avec un taux atomique d'aluminium compris entre 0,25 et 0,30.

Un tel composé avec un taux atomique d'aluminium de 0,27 noté Al_{0,27}Ga_{0,73}As donne un indice optique environ égal à 3,37. A titre d'exemple, les couches de revêtement employées peuvent être en Al_{0,30}Ga_{0,70}As donnant un écart d'indice de 0,016.

Par ailleurs, la région centrale peut comprendre :
- une couche barrière inférieure semi-conductrice et non dopée disposée entre la première partie inférieure et la couche active,
- une couche barrière supérieure semi-conductrice et non dopée disposée entre la première partie supérieure et la couche active,
   les couches barrières inférieure et supérieure selon l'invention pouvant être en un même matériau semi-conducteur, pour une structure plus simple, et de préférence en un même composé contenant de l'arsenic, du gallium et de l'aluminium.

Plus le taux d'aluminium est élevé plus l'indice optique est faible. Un indice optique élevé au voisinage de la couche active permet de garder un confinement optique suffisant.

Dans un mode de réalisation de l'invention, au moins l'une des couches barrières est de type GRIN et présente un indice optique au voisinage de la couche active supérieur à l'indice optique au voisinage de la couche guidante adjacente pour un meilleur fonctionnement du guide optique.

Les caractéristiques et objets de la présente invention ressortiront de la description détaillée donnée ci-après en regard des figures annexées, présentées à titre illustratif et nullement limitatif.

Dans ces figures :
- la figure 1 représente schématiquement les profils respectifs d'indice optique et de taux atomique d'aluminium de couches semi-conductrices en fonction de leur position verticale dans un laser à semi-conducteurs selon l'invention dans un premier mode de réalisation,
- la figure 2 représente schématiquement les profils respectifs d'indice optique et de taux atomique d'aluminium de couches semi-conductrices en fonction de leur position verticale dans un laser à semi-conducteurs selon l'invention dans un second mode de réalisation.

Un laser à semi-conducteurs selon l'invention peut être utilisé dans des applications haute puissance et notamment comme source de pompage à 0,980 µm dans des fibres optiques.

Bien entendu, un laser selon l'invention comprend classiquement un substrat de type GaAs sur lequel est déposée par exemple par épitaxie de type MOVPE (Metal Organic Vapor Phase Epitaxy), d'abord une couche de revêtement inférieure 1. Notons également que le substrat peut comprendre une couche dite tampon en GaAs épitaxiée par exemple de quelques centaines de nanomètres afin de favoriser la croissances des couches suivantes.

Le laser selon l'invention comprend également de façon connue une couche de contact semi-conductrice fortement dopée de type p superposée à une couche de revêtement supérieure 2 ainsi qu'une couche électrode métallique dopée p déposée sur la couche de contact et reliée à une alimentation en courant.

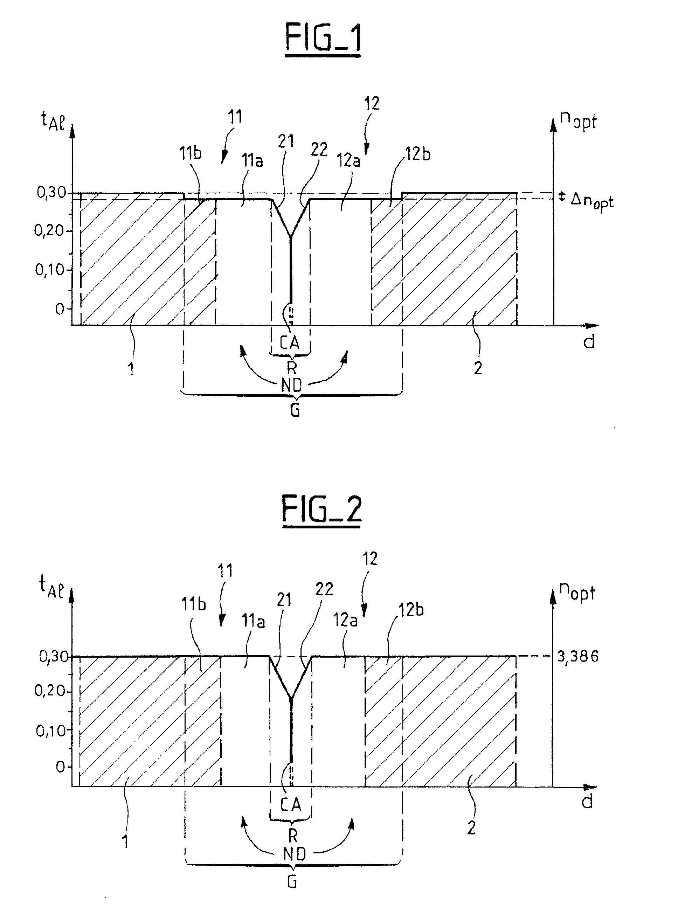

On a représenté schématiquement en figure 1 les profils respectifs d'indice optique nₒₚₜ et de taux atomique d'aluminium t_{Al} de couches semi-conductrices en fonction de leur position verticale d dans un laser à semi-conducteurs selon l'invention dans un premier mode de réalisation.

Dans ce premier mode de réalisation, le laser à structure verticale selon l'invention comporte dans cet ordre :
- la couche de revêtement inférieure 1 semi-conductrice et dopée de type n, en Al_{0,30}Ga_{0,70}As, d'épaisseur par exemple de l'ordre de 2 µm,
- un large guide optique G,
- la couche de revêtement supérieure 2, semi-conductrice, dopée de type p, en Al_{0,30}Ga_{0,70}As,d'épaisseur par exemple de l'ordre de 2 µm.
   Le large guide G comprend lui même dans cet ordre :
   - une couche guidante inférieure 11 semi-conductrice, en Al_{0,27}Ga_{0,73}As, d'épaisseur totale égale à 0,6 µm environ, comprenant :
      - une première partie inférieure 11a non dopée adjacente à la région centrale R, d'épaisseur égale à 0,4 µm environ,
      - une deuxième partie inférieure 11b dopée de type n et adjacente à la couche de revêtement inférieure 1, d'épaisseur égale à 0,2 µm environ,
- une région centrale R comprenant successivement :
   - une couche barrière inférieure 21 semi-conductrice et non dopée, par exemple de type GRIN, en AlₓGa₁₋ₓAs, x variant de 0,27 à 0,18, d'épaisseur comprise entre 80 et 100 nm,
   - une couche active semi-conductrice CA, non dopée, comprenant au moins un puits quantique, en GaAs ou en InGaAs et d'épaisseur comprise entre 7 et 10 nm,
   - une couche barrière supérieure 22 semi-conductrice, non dopée, par exemple de type GRIN, en AlₓGa₁₋ₓAs, x variant de 0,18 à 0,27, d'épaisseur comprise entre 80 et 100 nm,
- une couche guidante supérieure 12 semi-conductrice, en Al_{0,27}Ga_{0,73}As, d'épaisseur totale égale à 0,6 µm environ comprenant :
   - une première partie supérieure 12a non dopée adjacente à la région centrale R, d'épaisseur égale à 0,4 µm environ,
   - une deuxième partie supérieure 12b dopée de type p et adjacente à la couche de revêtement supérieure 2, d'épaisseur égale à 0,2 µm environ,

Les couches dopées présentées en trait hachuré sont donc les couches de revêtement 1, 2 et les deuxième parties inférieures et supérieures 11b, 12b. Les première parties inférieure et supérieure 11a, 12a forment une région intentionnellement non dopée ND d'épaisseur égale à environ 0,8 µm.

Comme le montre la figure 1, la différence d'indice optique Δnₒₚₜ entre chaque couche de revêtement 1, 2 et chaque couche guidante adjacente 11, 12 et est sensiblement égale à 0,016.

Le laser présente une divergence verticale comprise entre 23 et 25° et des faibles pertes internes aux environs de 1,5 cm⁻¹. La somme des épaisseurs des couches guidantes inférieure et supérieure 11, 12 est égale à 1,2 µm. Notons qu'une augmentation de l'épaisseur à 1,4 µm par une augmentation de 0,1 µm de l'épaisseur de chaque deuxième partie 11b, 12b donne avantageusement une divergence verticale comprise entre 21 et 23° et de très faibles pertes internes inférieures à 1 cm⁻¹.

On a représenté schématiquement en figure 2 les profils respectifs d'indice optique nₒₚₜ et de taux atomique d'aluminium t_{Al} de couches semi-conductrices en fonction de leur position verticale dans un laser à semi-conducteurs selon l'invention dans un deuxième mode de réalisation.

Nous ne présentons que les différences par rapport au premier mode de réalisation.

Les couche barrières inférieure et supérieure 21, 22 sont en AlₓGa₁₋ₓAs, x variant de 0,18 à 0,30.

Les couches guidantes inférieure et supérieure 11, 12 sont en Al_{0,30}Ga_{0,70}As d'indice optique égal à environ 3,386 et possèdent chacune une épaisseur totale égale à 0,7 µm environ. Les deuxièmes parties supérieures et inférieure 11b, 12b possèdent une épaisseur égale à 0,3 µm environ.

Comme le montre la figure 2, la différence d'indice optique entre chaque couche de revêtement 1, 2 et chaque couche guidante adjacente 11, 12 est sensiblement égale à zéro.

Ce laser selon le deuxième mode de réalisation de l'invention présente une divergence verticale comprise entre 13° et 16° et des pertes internes inférieures à 1,5 cm⁻¹.

La description qui précède a été donnée à titre purement illustratif. On pourra sans sortir du cadre de l'invention remplacer tout moyen par un moyen équivalent.

Le choix des composés constituants la couche active et les couches barrières, de même que le choix des composés constituants les couches guidantes et les couches de revêtement adjacentes sont donnés à titre indicatif.

On peut par exemple employer des composés ternaires ou quaternaires semi-conducteurs tels que les composés d'InₓGa₁₋ₓP, d'InₓGa₁₋ₓAs, ou d'InGaAsP.

De même, on peut aussi bien employer des couche barrières à indice optique constant que des couches barrières de type GRIN. Le type de GRIN peut être aussi bien linéaire que parabolique.

En outre, le taux de dopage dans les deuxièmes parties inférieure et supérieure selon l'invention peut être constant sur toute l'épaisseur de ces couches ou être inférieure au voisinage des premières parties inférieure et supérieure.

Le laser selon l'invention peut être de type ruban enterré ou d'autres types.

Les modes de réalisation présentés sont des lasers monomode transverse. L'invention s'applique également à des lasers dont la propagation de la lumière est de type multimode transverse tels que les lasers dits à contact large ou les barrettes de lasers de puissance multirubans.

## Revendications

1. Laser à semi-conducteurs de structure verticale comportant
- une couche de revêtement inférieure (1) semi-conductrice et dopée de type n,
- un guide optique (G) superposé à la couche de revêtement inférieure, ledit guide comportant une région centrale (R) comprenant au moins une couche active semi-conductrice (CA),
- une couche de revêtement supérieure (2), semi-conductrice, dopée de type p, et superposée audit guide optique,
**caractérisé en ce que** ledit guide optique comprend en outre :
- une couche guidante inférieure (11) semi-conductrice comprenant deux parties adjacentes dites inférieures suivantes :
- une première partie inférieure (11a) non dopée adjacente à la région centrale,
- une deuxième partie inférieure (11b) dopée de type n et adjacente à la couche de revêtement inférieure,
- une couche guidante supérieure (12) semi-conductrice comprenant deux parties adjacentes dites supérieures suivantes:
- une première partie supérieure (12a) non dopée adjacente à la région centrale,
- une deuxième partie supérieure (12b) dopée de type p et adjacente à la couche de revêtement supérieure,
- **en ce que** les premières parties inférieure et supérieure forment une région non dopée (ND) d'épaisseur supérieure à 0,5 µm,
et **en ce que** la différence d'indice optique (Δnₒₚₜ) entre au moins l'une des couches de revêtement et ladite couche guidante adjacente est inférieure à 0,02.

2. Laser à semi-conducteurs selon la revendication 1 **caractérisé en ce que** l'épaisseur de la région non dopée (ND) est sensiblement égale à 0,8 µm.

3. Laser à semi-conducteurs selon l'une des revendications 1 ou 2 **caractérisé en ce que** la somme des épaisseurs des couches guidantes inférieure et supérieure (11, 12) selon l'invention est comprise entre 1,2 µm et 1,5 µm.

4. Laser à semi-conducteurs selon l'une des revendications 1 à 3 **caractérisé en ce que** ladite différence d'indice optique entre au moins l'une desdites couches de revêtement (1, 2) et la couche guidante adjacente (11, 12) est sensiblement égale à zéro.

5. Laser à semi-conducteurs selon l'une des revendications 1 à 4 **caractérisé en ce que** lesdites couches guidantes inférieure et supérieure (11, 12) sont en un même matériau semi-conducteur et de préférence en un composé contenant de l'arsenic, du gallium et de l'aluminium avec un taux atomique d'aluminium compris entre 0,25 et 0,30.

6. Laser à semi-conducteurs selon l'une des revendications 1 à 5 **caractérisé en ce que** ladite région centrale (R) comprend :
- une couche barrière inférieure (21) semi-conductrice et non dopée disposée entre la première partie inférieure (11a) et la couche active (CA),
- une couche barrière supérieure (22) semi-conductrice et non dopée, disposée entre la première partie supérieure (12a) et la couche active (CA),
les couches barrières inférieure et supérieure étant en un même matériau semi-conducteur.

7. Laser à semi-conducteurs selon la revendication 6 **caractérisé en ce que** les couches barrières inférieure et supérieure (21, 22) sont en un même composé contenant de l'arsenic, du gallium et de l'aluminium.

8. Laser à semi-conducteurs selon l'une des revendications 6 ou 7 **caractérisé en ce qu'**au moins l'une desdites couches barrières (21, 22) est de type GRIN et présente un indice optique au voisinage de ladite couche active (CA) supérieur à l'indice optique au voisinage de la couche guidante adjacente (11, 12).
